# EUROPÄISCHE PATENTSCHRIFT

(11) **EP 0 756 911 B1**
(45) Veröffentlichungstag und Bekanntmachung des Hinweises auf die Patenterteilung: **10.05.2000**
(21) Anmeldenummer: 96110442.9
(22) Anmeldetag: 28.06.1996
(51) Int. Cl.: B22D 13/02, B22F 9/10, B22F 9/04, B22D 27/04

(54) **Verfahren und Vorrichtung zum Herstellen von Partikeln aus gerichtet erstarrten Gusskörpern**
Process and apparatus for producing particles from directionally solified cast parts
Procédé et appareil pour la fabrication de particules de pièces coulées et solidifiées directionnellement

(30) Priorität: 02.08.1995 DE 19528291
(43) Veröffentlichungstag der Anmeldung: 05.02.1997
(73) Patentinhaber: ALD Vacuum Technologies AG, 63450 Hanau (DE)
(72) Erfinder: Hugo, Franz, Ing., 63743 Aschaffenburg (DE); Kemmer, Hans-Johann, Dipl.-Ing., 63322 Rödermark (DE); Sitzmann, Bernd, Dipl.-Ing., 63477 Maintal (DE); Protzmann, Michael, Dipl.-Ing., 63607 Wächtersbach (DE)
(74) Vertreter: Zapfe, Hans, Dipl.-Ing.

(56) Entgegenhaltungen:
- US-A- 3 816 189
- PATENT ABSTRACTS OF JAPAN vol. 006, no. 113 (M-138), 24.Juni 1982 & JP 57 041846 A (NIPPON KOKAN KK), 9.März 1982,
- PATENT ABSTRACTS OF JAPAN vol. 017, no. 226 (M-1405), 10.Mai 1993 & JP 04 358008 A (MITSUI MINING & SMELTING CO LTD), 11.Dezember 1992,
- PATENT ABSTRACTS OF JAPAN vol. 013, no. 445 (E-829), 6.Oktober 1989 & JP 01 171217 A (KOBE STEEL LTD;OTHERS: 01), 6.Juli 1989,

## Beschreibung

Die Erfindung betrifft ein Verfahren und eine Vorrichtung zum Herstellen von Partikeln aus gerichtet erstarrten Gußkörpern nach den Oberbegriffen der Patentansprüche 1 und 7.

Partikel aus bestimmten Legierungen, für die nachfolgend einige Anwendungsbeispiele angegeben sind, werden für neuere Technologien in großer Menge benötigt. Die Gewinnung kann entweder in Form von Metallstaub, feinem Granulat, oder von Klumpen, Brocken und regelmäßigen Formkörpern geschehen, die mehr oder weniger spröde sind und durch einen Mahlvorgang zerkleinert werden können . Von Bedeutung ist hierbei, daß die Partikel bzw. ihre Vorprodukte unter den Bedingungen einer "gerichteten Erstarrung" entstanden sind, weil dies den letztendlich aus den Partikeln hergestellten Endprodukten besonders günstige Eigenschaften verleiht. Die bisher bekannt gewordenen Versuche beschränkten sich darauf, die Partikel in begrenzten Chargenmengen herzustellen, wobei die Erstarrungsbedingungen aber nicht in dem wünschenswerten Umfange den Anforderungen an eine gerichtete Erstarrung genügen.

Ein erstes Anwendungsgebiet ist die Herstellung von Magnetwerkstoffen, beispielsweise mit Komponenten aus Lanthaniden wie Kobalt-Samarium-Magnete, die sich sämtlich durch extrem hohe Feldstärken auszeichnen.

Ein zweites Anwendungsgebiet sind beispielhaft wiederaufladbare Batterien, bei denen die Elektroden aus Nickel-Metallhydriden bestehen. Dieser Elektrodenwerkstoff wird bevorzugt anstelle des hochgiftigen Kadmiums verwendet, und zwar vorzugsweise in der Form intermetallischer einphasiger Verbindungen der Seltenerdmetalle mit der Kurzbezeichnung AB₅, oder mehrphasiger Legierungen aus Titan und Zirkonium mit Anteilen von Nickel, Kobalt, Mangan, Aluminium, Vanadium, Chrom, Eisen oder Silizium. Diese mehrphasigen Legierungen werden auch mit der Kurzbezeichnung AB₂ belegt.

Ein drittes Anwendungsgebiet sind beispielsweise die sogenannten Hydridspeicher bzw. Wasserstoffspeicher aus Legierungen wie Lanthan-Nickel, Titan-Eisen, Magnesium-Nickel, gegebenenfalls mit weiteren Komponenten aus der Gruppe Eisen, Titan, Zirkonium, Niob, Aluminium, Mangan, Lanthan und Kalzium.

Ein viertes Anwendungsgebiet sind Getter-Legierungen für andere Gase sowie Katalysatoren.

Eine Reihe von Herstellverfahren für die partikelförmigen Zwischenprodukte der angegebenen Endprodukte sowie deren physikalische und metallurgische Eigenschaften sind Stand der Technik, so daß hierauf nicht näher eingegangen zu werden braucht.

Schleudergießverfahren und -vorrichtungen zum Herstellen dichter und fester rotationssymmetrischer Gußkörper als Endprodukt aus den unterschiedlichsten Metallen und Legierungen sind gleichfalls in großer Zahl bekannt; sie wurden bisher aber nicht für die Herstellung von Partikeln für die oben angegebenen Einsatzgebiete verwendet.

Durch die JP-A-57041846 ist es bekannt, in einer gegenüber der Umgebungsluft offenen Schleudergußkokille mit einer Außenkühlung spröde Ferrolegierungen zu erzeugen, die durch Wärmespannungen reißen. Es werden in der Kokille Korngrößen kleiner als 30 mm und größer als 30 mm erzeugt, die nachfolgend zermahlen werden. Dabei wird die Korngröße durch auswechselbare Kokilleneinsätze beeinflußt. Korngrößen unterhalb von 30 mm werden in einem glatten Kokilleneinsatz, Korngrößen oberhalb von 30 mm in einem profilierten Kokilleneinsatz erzeugt. Über eine Wachstumsrichtung der Kristalle ist nichts ausgesagt, desgleichen nichts über die Verwendung der Endprodukte. Durch den Zutritt der Umgebungsluft werden jedoch Oxide gebildet, die die Eigenschaften der Ferrolegierungen negativ beeinflussen und insbesondere bei reaktiven Legierungskomponenten zu nicht brauchbaren Endprodukten führen. über den Kokillendurchmesser und die maximale Schichtdicke der Schmelze werden keine Angaben gemacht.

Durch die Patent Abstracts of Japan, Vol. 017, No. 226, und die JP-A 04 358008 ist es bekannt, Pulver für die Wasserstoffspeicherung dadurch herzustellen, daß man einen Block gießt, der zu mindestens 80 % aus Dendriten der Struktur B besteht. Das rohe Pulver für die Legierung wird dabei geschmolzen und auf eine Temperatur erhitzt, die mindestens 250 °C über dem Schmelzpunkt liegt, und dann in eine stationäre Kokille abgegossen, deren Wandabstände zwischen 20 und 100 mm liegen. Das Pulver wird dann durch Zermahlen des gegossenen Blocks hergestellt. Von einem Schleuderguß ist nicht die Rede.

Durch die nächstkommende JP-A-0 1171217 ist es bekannt, in einer gleichfalls gegenüber der Umgebungsluft offenen Schleudergußkokille rohrförmige Permanentmagnete aus Seltenen Erden, Eisen und Bor zu erzeugen, die in einem Vakuumschmelzofen erschmolzen worden sind. Durch den Einfluß der Umgebungsluft beim Schleudergießen wird jedoch die positive Wirkung des Vakuums beim Erschmelzen größtenteils wieder zunichte gemacht. Durch Wahl der Gießtemperaturen zwischen 1250 °C und 1600 °C und der Zentrifugalkräfte zwischen 100 G und 200 G wird dabei die Wachstumsrichtung der Kristalle in radialer oder axialer Richtung beeinflußt. Bei einer Länge von 200 mm haben die Rohmagnete Außendurchmesser von 80 mm und Innendurchmesser von 40 mm, d.h. das Verhältnis von Wandstärke (20 mm) zu Außendurchmesser (= Durchmesser der Kühlfläche) beträgt 25%. Das Gewicht beträgt also nur wenige Kilogramm, und es ist als Verfahren zur Weiterbearbeitung lediglich eine Warmverformung, nicht aber eine Zerkleinerung vorgesehen. Die Rohmagnete werden nämlich nicht zerkleinert, sondern nach dem Einhüllen in einen Mantel durch Strangpressen im Durchmesser weiter verringert. Es hängt bei diesem Verfahren sehr stark von den Verfahrensparametern beim Schleudergießen ab, ob eine gerichtete Erstarrung oder eine Erstarrung von innen und von außen her erfolgt, in welchem Falle die gerichtete Erstarrung in der Mitte der Wandstärke durch eine Kornstruktur unterbrochen ist, die als "equi-axed" (achsparallel) bezeichnet wird. Für die Herstellung großer Mengen von pulverförmigen Partikeln aus den besagten Magnetwerkstoffen ist das bekannte Verfahren weder vorgesehen noch geeignet.

Durch die DE 25 28 843 C2 ist es bekannt, hochfeste, ringförmige Gußteile dadurch herzustellen, daß man eine metallische Schmelze durch eine mit hoher Drehzahl angetriebene Zentrifuge zerstäubt und gegen eine konzentrisch angeordnete Ringform schleudert, die selbst keine Rotation ausführt. Beim Aufprall werden die Metalltröpfchen pfannkuchenartig verformt und bilden einen in sich festen, gegebenenfalls schichtartigen Aufbau, der erforderlichenfalls noch durch Nachbearbeitung weiter verfestigt werden soll. Eine gerichtete Erstarrung ist auf diese Weise nicht durchzuführen, eine Zerkleinerung nicht nur nicht vorgesehen, sondern ausdrücklich ausgeschlossen.

Es sind weiterhin Verfahren zum Herstellen von Partikeln aus spröden Legierungen bekannt, wobei in jeweils einem ersten Verfahrensschritt platten- oder scheibenförmige Gußkörper hergestellt werden, indem die Legierungsschmelzen zentral auf ebene Kühlplatten aufgegossen werden. Diese Kühlplatten können sich auf der äußeren Oberfläche einer polygonalen Trommel, auf einem Plattenbandförderer befinden oder auch stationär angeordnet sein. In diesen Fällen erfolgt die Ausbreitung der Schmelze in radialen horizontalen Richtungen lediglich unter der Wirkung der Schwerkraft, also mit relativ sehr geringer Ausbreitungsgeschwindigkeit, so daß die Schmelze bereits zumindest teilweise erstarrt, bevor sie die Ränder der Kühlplatte erreicht. In diesem Falle erfolgt die Erstarrung in willkürlichen Richtungen.

Es ist weiterhin bekannt, relativ kleine Platten aus spröden Legierungen zwischen senkrechten, gekühlten Wänden herzustellen, wobei notwendigerweise eine Erstarrung von beiden Seiten her erfolgt, so daß sich in der Mitte wiederum eine Kristallstruktur ausbildet, die als "equi-axed" zu bezeichnen ist. Auch das Aufgießen von Schmelzen aus spröden Legierungen auf schiefe Ebenen und die Ausbreitung der Schmelze unter der Wirkung der Schwerkraft ist bekannt. Auch in einem solchen Fall treten die bereits beschriebenen Nachteile einer vorzeitigen Erstarrung und einer unkontrollierbaren Erstarrungsrichtung auf.

Bei dem zuletzt beschriebenen Stand der Technik mit ebenen Kühlplatten werden die erstarrten und mehr oder weniger spröden plattenförmigen Gußkörper durch einen Mahlvorgang in Partikel umgewandelt, die als Zwischenprodukt für die Weiterverarbeitung zu den gewünschten Endprodukten vorgesehen sind, was in der Regel durch Pressen und Sintern oder Kunststoffbindung geschieht. In allen Fällen werden jedoch nur geringe Partikelmengen pro Arbeitsgang erzeugt, so daß sich die Herstellung der Partikel äußerst kostenaufwendig gestaltet.

Der Erfindung liegt daher die Aufgabe zugrunde, ein Verfahren und eine Vorrichtung der eingangs beschriebenen Gattung anzugeben, durch das Partikel aus den angegebenen Legierungen in großen Mengen kostengünstig und mit einem engen Korngrößenspektrum hergestellt werden können.

Die Lösung der gestellten Aufgabe erfolgt bei dem eingangs angegebenen Verfahren erfindungsgemäß durch die Merkmale im Kennzeichen des Patentanspruchs 1.

Durch das Prinzip des Schleudergießens erfolgt unter dem Einfluß der Zentrifugalkräfte, die ein Vielfaches der Erdbeschleunigung betragen können, eine außerordentlich rasche und zuverlässige Ausbreitung der Schmelze, die ihre jeweilige Endposition erreicht, bevor die Erstarrung weiter fortgeschritten ist.

Der Gußkörper hat auch auf seiner Innenseite eine außerordentlich dichte, aber einachsig bzw. radial ausgerichtete Struktur und ist vollständig frei von Lunkern oder anderen porösen oder zerklüfteten Stellen. Bei den meisten der in Frage kommenden Legierungen ist der betreffende Hohlkörper auch außerordentlich spröde und läßt sich bereits durch geringe äußere Kräfte in Brocken oder Klumpen zerlegen, die durch einen Zerkleinerungsprozeß in den gewünschten Endzustand gebracht werden können. Die betreffenden Partikel liegen dabei innerhalb eines außerordentlich engen und durch die hohe Abschreckgeschwindigkeit feinen Korngrößenspektrums und lassen sich daher für die erforderliche Weiterverarbeitung zu den endgültigen Raumformen sehr gut weiterverarbeiten.

Es ist dabei im Zuge einer weiteren Ausgestaltung der Erfindung besonders vorteilhaft, wenn man die Schmelze auf die rotierende Kühlfläche in einer Dicke aufbringt, die maximal 5 % des Durchmessers der Kühlfläche beträgt.

Versuche haben ergeben, daß man den Durchmesser der Kühlfläche ohne weiteres bis auf 2000 mm und ihre Länge auf 4000 mm und darüber steigern kann, wobei der Gußkörper schließlich eine Wandstärke zwischen etwa 20 und 50 mm hat. Auf diese Weise wird durch einen einzigen Arbeitsgang eine Charge von mehreren 100 Kilogramm Gewicht erzielt. Dadurch lassen sich aus einer einzigen Charge eine Vielzahl von Endprodukten mit den geforderten Eigenschaften herstellen. Bei den sogenannten Hydridspeichern ist die wesentliche Eigenschaft die, daß eine relativ poröse Struktur der Endprodukte erzielt wird, die mit geringem Strömungswiderstand von Wasserstoff durchströmt werden kann, so daß die betreffenden Endprodukte den Wasserstoff mit hoher Geschwindigkeit aufnehmen und auch wieder abgeben können.

Es ist dabei im Zuge einer wiederum weiteren Ausgestaltung des Erfindungsgegenstandes besonders vorteilhaft, wenn man mindestens einen Schmelzenstrahl unter axialer Verschiebung parallel zur Rotationsachse AR-AR zunächst auf die Kühlfläche und danach auf eine bereits zumindest teilweise abgekühlte Schicht des Gußkörpers aufbringt.

Durch diese Maßnahme, die auf einer zeitlichen Verteilung des Gießvorganges beruht, wird der Gußkörper gewissermaßen schichtweise "gewickelt", und die von der Anfangsschicht erzeugte Wachstumsrichtung der Kristalle wird in jeder neuen aufgebrachten Schmelzenschicht fortgesetzt. Diese Verfahrensweise steht im Gegensatz zum üblichen Schleudergießen, bei dem nach Möglichkeit' die gesamte Schmelze innerhalb kürzester Zeit in die Schleudergießform eingebracht wird.

Weitere vorteilhafte Ausgestaltungen des erfindungsgemäßen Verfahrens ergeben sich aus den übrigen Verfahrensansprüchen.

Der Ausdruck "in nichtreaktiver Atmosphäre" besagt, daß das erfindungsgemäße Verfahren entweder unter Vakuum oder Schutzgas durchgeführt werden kann, wie beispielsweise unter Stickstoff und/oder Argon. Vakuum verhindert die Oxidation der Schmelze und des Gußkörpers, Schutzgas verhindert zusätzlich das Ausdampfen leichtflüchtiger Komponenten wie z.B. von Mangan, Aluminium, Chrom, Magnesium oder dergleichen.

Die erfindungsgemäße Vorrichtung zum Durchführen des vorstehend beschriebenen Verfahrens ist gekennzeichnet durch die Merkmale im Kennzeichen des Patentansspruchs 7.

Es ist dabei weiterhin von Vorteil, wenn der Durchmesser der Kühlfläche mindestens 500 mm, beträgt.

Es ist dabei im Zuge einer weiteren Ausgestaltung der Erfindung besonders vorteilhaft, wenn die Schleudertrommel einseitig offen und in der Kammer angeordnet ist, und wenn die Kammer auf der offenen Seite der Schleudertrommel eine Tür besitzt, an der eine Abgußvorrichtung für die Schmelze angeordnet ist.

Eine besonders einfache Vorrichtung ist gemäß der weiteren Erfindung dadurch gekennzeichnet, daß die Schleudertrommel mit ihrer Kühlfläche selbst mindestens einen Teil einer gasdichten Kammer bildet.

Eine Vorrichtung, die sich ganz besonders zur Herstellung großer Mengen von pulverförmigen Partikeln in einer einzigen Charge eignet, ist gemäß einer weiteren Ausgestaltung der Erfindung dadurch gekennzeichnet, daß die Schleudertrommel um eine waagrechte Kippachse schwenkbar ist, die senkrecht zur Rotationsachse verläuft, und daß eine beim Kippen nach unten gelangende, beim Gießen durch eine Verschlußwand verschließbare Öffnung der Schleudertrommel die Entleerung des erstarrten Gußkörpers oder seiner Teile nach unten ermöglicht.

Die Entleerung der Schleudertrommel kann im Stillstand durch leichtes Klopfen oder Rütteln begünstigt werden, bei Gußkörpern mit höherer Festigkeit auch dadurch, daß man die Wandung oder Wandungen der Schleudertrommeln mit radial ausgerichteten Gewindebohrungen versieht, durch die Schrauben gegen den Gußkörper verspannt werden können, der unter der Wirkung der Schraubenbewegung zu Brocken oder Klumpen zerfällt.

Es ist dabei weiterhin von Vorteil, wenn durch die besagte Verschlußwand eine Gießrinne in die Schleudertrommel einführbar ist, wenn vor der Außenseite der Verschlußwand eine Rückzugskammer für die Gießrinne angeordnet ist und wenn die Schleudertrommel über die Verschlußwand gasdicht mit der Rückzugskammer verbindbar ist. Bevorzugt ist die Rückzugskammer mit einer Heizeinrichtung ausgestattet, durch die die Gießrinne auf der erforderlichen Betriebstemperatur gehalten werden kann, so daß der nächste Verfahrenszyklus kurzfristig durchgeführt werden kann.

Es ist weiterhin von Vorteil, wenn die Gießrinne auf ihrer über die Kühlfläche verschiebbaren Teillänge mit mehreren Austrittsöffnungen zur Ausbildung mehrerer Gießstrahlen versehen ist. Auf diese Weise läßt sich eine große Baulänge der Kühltrommel erreichen, und dennoch wird die Kühlfläche der Kühltrommel zumindest im wesentlichen gleichzeitig auf der besagten Teillänge mit Schmelze versorgt. Diese Maßnahme dient zu einer weiteren Steigerung der Produktionsgeschwindigkeit der Vorrichtung.

Weitere vorteilhafte Ausgestaltungen der erfindungsgemäßen Vorrichtung ergeben sich aus den übrigen Vorrichtungsansprüchen.

Vier Ausführungsbeispiele des Erfindungsgegenstandes werden nachfolgend anhand der Figuren 1 bis 6 näher erläutert.

Es zeigen:
- Figur 1: einen Axialschnitt durch ein erstes Ausführungsbeispiel einer Vorrichtung mit Mitteln zur Gaskühlung der Kühlfläche,
- Figur 2: einen Axialschnitt analog Figur 1 durch ein zweites führungsbeispiel einer erfindungsgemäßen Vorrichtung mit Mitteln zur Flüssigkeitskühlung der Kühlfläche,
- Figuren 3, 4 und 5: einen Radialschnitt und zwei Axialschnitte in unterschiedlichen Betriebspositionen durch ein drittes Ausführungsbeispiel des Erfindungsgegenstandes, wobei die Figur 3 einen Radialschnitt entlang der Linie III-III in Figur 4 zeigt,
- Figur 6: einen Axialschnitt durch ein viertes Ausführungsbeispiel einer Produktionsanlage mit einer besonders großen Produktionskapazität.

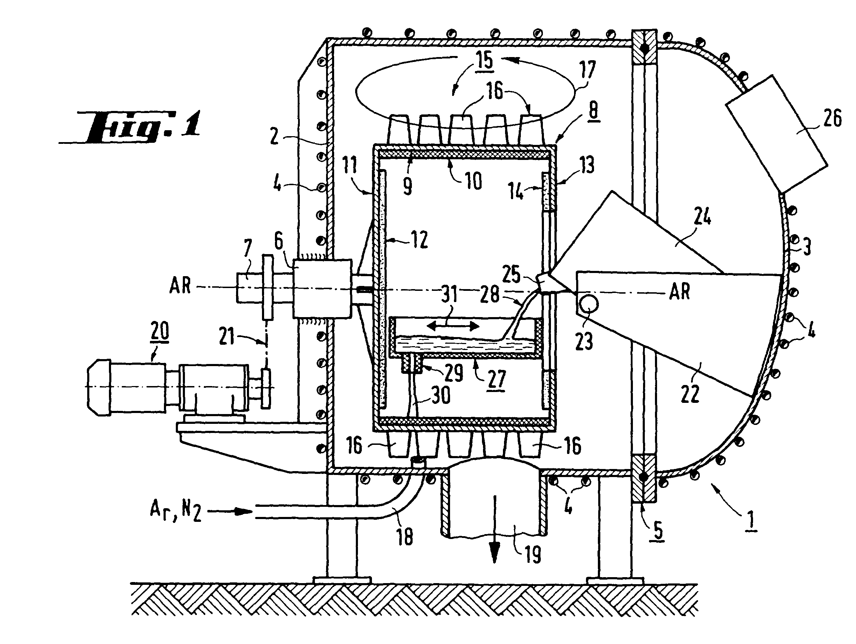

In Figur 1 ist eine gasdichte Kammer 1 mit liegender Achse, einem Kammerhauptteil 2 und einer Tür 3 dargestellt, auf deren Oberflächen Kühlrohre 4 wärmeleitend befestigt sind. Zwischen dem Kammerhauptteil 2 und der Tür 3 befindet sich eine Flanschverbindung 5. In einer senkrechten Wand des Kammerhauptteils 2 befindet sich eine gasdichte Drehdurchführung 6 für eine Welle 7, an der innerhalb der Kammer 1 eine Schleudertrommel 8 mit einer waagrechten Rotationsachse AR-AR befestigt ist. Die Schleudertrommel 8 besitzt auf ihrer Innenseite eine zylindrische Kühlfläche 9, auf der sich ein bereits teilweise verfestigter Gußkörper 10 befindet, der in der Entstehung begriffen ist. Die Schleudertrommel 8 besitzt weiterhin eine geschlossene Stirnwand 11, an der die Welle 7 befestigt ist und die auf ihrer Innenseite auf dem größten Teil ihrer Oberfläche mit einem kreisscheibenförmigen Isolierkörper 12 versehen ist. Die gegenüberliegende Seite der Schleudertrommel 8 besitzt eine kreisringförmige Stirnwand 13, die auf ihrer Innenseite mit einem kreisringförmigen Isolierkörper 14 belegt ist. Die Isolierkörper 12 und 14 haben die Aufgabe, eine seitliche und nach innen gerichtete Wärmeabstrahlung vom Gußkörper 10 soweit wie irgend möglich zu unterbinden.

Auf der Außenseite der Schleudertrommel 8 befindet sich eine Einrichtung 15 zur Zwangskühlung, und im Fall der Figur 1 besteht diese Einrichtung 15 aus insgesamt 5 Kränzen von Gebläseschaufeln 16, die gleichzeitig die Wirkung von Kühlrippen haben. Durch eine Schrägstellung der Gebläseschaufeln gegenüber den Mantellinien der Schleudertrommel 8 wird erreicht, daß die Gebläseschaufeln bei der Rotation der Schleudertrommel 8 eine axiale Förderbewegung auf eine in der Kammer 1 befindliche Gasatmosphäre ausüben. Die Kühlwirkung ist natürlich gering, wenn die Kammer 1 unter Vakuum betrieben wird. Nach dem Fluten mit einem Inertgas kann jedoch die Abkühlgeschwindigkeit ganz erheblich gesteigert werden. In diesem Falle bildet sich nämlich eine Gasströmung aus, die - grob gesehen - dem Pfeil 17 entspricht. Mit anderen Worten: Die Gasatmosphäre in der Kammer 1 wird von den Gebläseschaufeln 16 über die Innenflächen der gekühlten Kammer 1 geleitet, wodurch ein intensiver Wärmeaustausch von der Kühlfläche 9 zur Kammer 1 erfolgt. Das Fluten der Kammer 1 mit einem Inertgas wie beispielsweise Argon oder Stickstoff erfolgt über eine Gasleitung 18, die mit einer nicht gezeigten und absperrbaren Gasquelle verbunden ist. Über einen Saugstutzen 19 ist die Kammer 1 mit einem hier nicht gezeigten Satz von Vakuumpumpen verbunden.

Zum Antrieb der Schleudertrommel 8 dient ein Getriebemotor 20, der über einen Riementrieb 21 mit der Welle 7 verbunden ist.

An der Tür 3 sind zwei Konsolen 22 befestigt, von denen nur die vordere sichtbar ist, und zwischen denen sich eine Kippachse 23 für einen induktiv beheizten Schmelztiegel 24 befindet, der eine Gießlippe 25 besitzt. Der Kippantrieb, die Zuführungsleitungen für den Schmelzstrom und das Kühlwasser sind der Einfachheit halber nicht dargestellt; der Gießvorgang ist durch ein Sichtfenster 26 zu beobachten. Zwischen die Kühlfläche 9 und den Kipptiegel 4 ist eine Gießrinne 27 geschaltet, in die über die Gießlippe 25 ein erster Gießstrahl 28 geleitet wird. Die Gießrinne ist mit mindestens einer Austrittsöffnung 29 zur Erzeugung eines zweiten Gießstrahls 30 versehen, der zur Beschickung der Kühlfläche 9 dient. Durch eine hier nicht gezeigte Horizontalführung und einen Antrieb läßt sich die Gießrinne 27 in Richtung des Doppelpfeils 31 bewegen, vorzugsweise in einer changierenden Bewegung, so daß der Gießstrahl 33 über zumindest einen großen Teil der Kühlfläche 9 bewegt werden kann, wodurch sich eine Art "gewickelter Aufbau" des Gußkörpers 10 ergibt, wie dies in der allgemeinen Beschreibung erläutert wird.

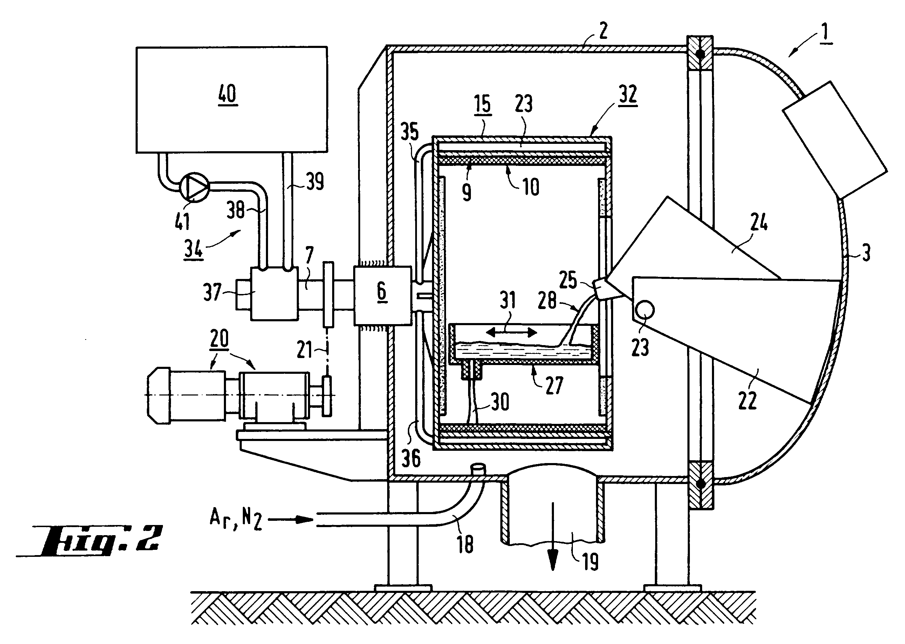

Die Figur 2 unterscheidet sich im wesentlichen dadurch von der Figur 1, daß die Schleudertrommel 32 auf ihrem Außenumfang in der Breite der Kühlfläche 9 mit einem Hohlraum 33 versehen ist, der an einen Kühlmittelkreislauf 34 angeschlossen ist. Zu diesem Zweck ist die Welle 7 mit hier nicht gezeigten Längskanälen versehen, die über radiale Leitungen 35 und 36 mit dem Hohlraum 33 verbunden sind, Jenseits des Riementriebs 21 ist die Welle 7 mit einer Rotationskupplung 37 versehen, in die zwei Leitungen 38 und 39 einmünden, die mit einem Wärmetauscher 40 zur Rückkühlung eines flüssigen Kühlmediums, vorzugsweise Wasser, verbunden sind. Eine Pumpe 41 dient zur Umwälzung des Kühlmediums. Auf diese Weise läßt sich eine hohe Abkühlgeschwindigkeit der Schmelze zur Bildung des Gußkörpers 10 erreichen.

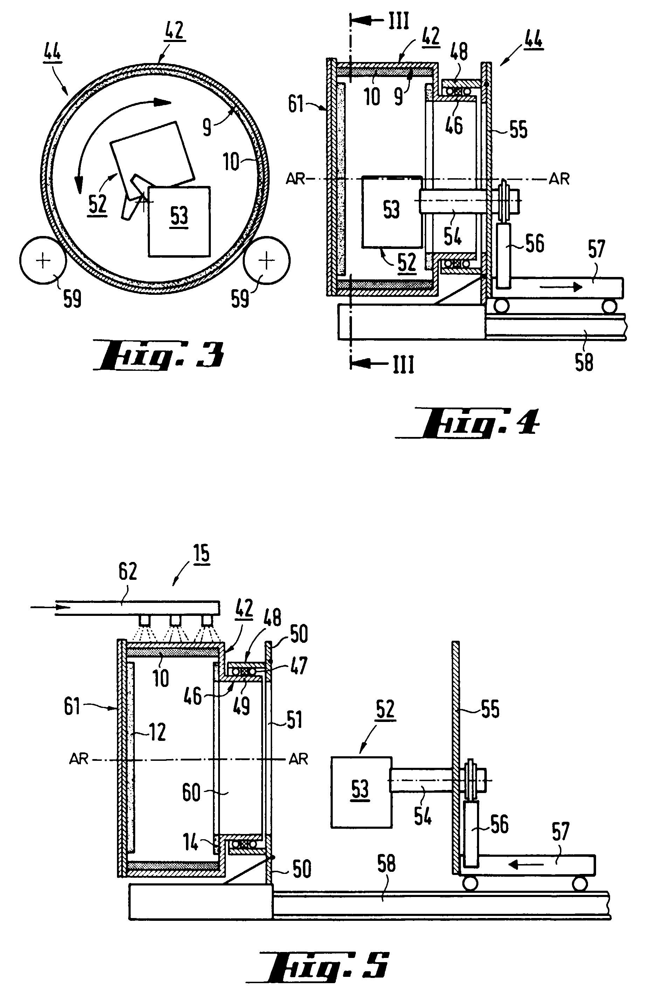

In den Figuren 3 bis 5 und 6 sind zwei weitere Ausführungsbeispiele in gegenüber den Figuren 1 und 2 stark verkleinertem Maßstab gezeigt, bei denen die Schleudertrommeln 42 bzw. 43 mit ihrer Kühlfläche 9 selbst den größten Teil gasdichter Kammern 44 bzw. 45 bilden, so daß eine äußere gasdichte Kammer nicht mehr erforderlich ist. Dies hat eine Verringerung der Investitions- und Betriebskosten zur Folge, d.h. die Zeiten für einen Gasaustausch bzw. für eine Evakuierung der kompletten Anlage werden drastisch verringert.

Beim Ausführungsbeispiel nach den Figuren 3 bis 5 ist die Schleudertrommel 42 drehfest mit einem Ringfortsatz 46 verbunden, der gasdicht über ein Radiallager 47 mit einem stationären Lagerring 48 zusammenwirkt. Eine Ringdichtung 49 ist zwischen den beiden nicht näher bezifferten Wälzlagerkränzen kreuzschraffiert eingezeichnet. Der stationäre Lagerring 48 ist an einer Kammerwand 50 befestigt, die im Innern des Lagerrings 48 mit einer Öffnung 51 versehen ist, die zum Einführen einer Gießvorrichtung 52 dient, die auch in diesem Falle als induktiv beheizbarer Schmelztiegel 53 ausgeführt ist. Die Gießvorrichtung 52 ist mittels eines drehbaren Auslegers 54 an einer Verschlußplatte 55 befestigt, die zum Verschluß der Öffnung 51 dient. Zur Herbeiführung der Kippbewegung, die in ihren beiden Endstellungen in Figur 3 dargestellt ist, dient ein Kippantrieb 56, der zusammen mit der Schlußplatte 55 in der gezeigten Weise an einem Fahrgestell 57 befestigt ist, das auf Schienen 58 in Richtung der eingezeichneten Pfeile verfahrbar ist.

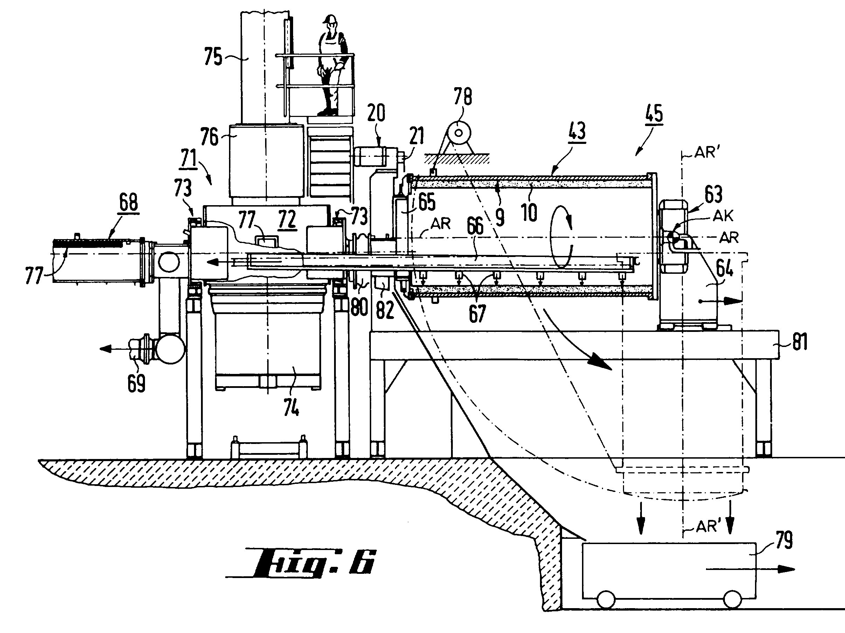

Die Schleudertrommel 44 ist gemäß Figur 3 auf Rollen 59 gelagert, von denen mindestens eine mit einem Antrieb verbunden ist. Auf diese Weise ist die Schleudertrommel 42 um die Rotationsachse AR-AR drehbar. Figur 4 zeigt die Anlage in geschlossenem Zustand. Während des Abgießens der Schmelze aus dem Schmelztiegel 53 entgegen dem Uhrzeigersinn in Figur 3 rotiert die Schleudertrommel 42 mit hoher Drehzahl, so daß die Schmelze sofort auf der Kühlfläche 9 verteilt wird, und zwar sowohl in Umfangsrichtung, als auch in einer Richtung parallel zur Rotationsachse AR-AR. Der zuletzt beschriebene Vorgang kann verstärkt werden, wenn der Schmelztiegel 53 eine hier nicht gezeigte changierende Bewegung parallel zur Rotationsachse AR-AR ausführt. Durch kontinuierlichen Abguß der Schmelze wird von außen nach innen allmählich der Gußkörper 10 aufgebaut, wobei die Wärme radial nach außen abgeführt und der Kristallisationsvorgang radial nach innen herbeigeführt wird. Auch hierbei werden Strahlungsverluste zur Seite hin durch die Isolierkörper 12 und 14 soweit wie irgend möglich verhindert. Nach dem vollständigen Entleeren des Schmelztiegels 53 wird dieser wieder in die Ausgangsstellung zurückgeschwenkt, und die Abkühlung des Gußkörpers 10 wird solange durchgeführt, bis die Kammer 44 geflutet werden kann, ohne daß der Luftsauerstoff die Beschaffenheit des Gußkörpers gefährdet.

Figur 5 zeigt die Anlage nach Figur 4 in geöffnetem Zustand in dem auch der Schmelztiegel 53 mit neuem Schmelzgut beschickt werden kann. Der Gußkörper 10 kann auf unterschiedliche Weise der Schleudertrommel 42 entnommen werden. Bei besonders spröden Legierungen läßt sich der Gußkörper 10 leicht zerteilen, so daß er durch die Öffnung 60 im Ringfortsatz 46 und durch die Öffnung 51 in der Kammerwand 50 entnommen werden kann. Bei Werkstoffen, die nicht ganz so spröde sind, läßt sich der Gußkörper 10, der durch den Abkühlvorgang geschrumpft ist, nach dem Abschrauben der Stirnwand 61 der Schleudertrommel 42 entnehmen und anschließend zerkleinern.

Die Abkühlgeschwindigkeit läßt sich auf eine in Figur 5 gezeigte Weise vergrößern, nämlich dadurch, daß auf die Außenseite der Schleudertrommel 42 eine Einrichtung 62 zur Berieselungskühlung ausgerichtet ist. Diese Einrichtung ist in den Figuren 3 und 4 der Einfachheit halber fortgelassen worden. In diesem Falle ist es zweckmäßig, die Schleudertrommel 42 allseitig mit einem Spritzschutz zu umgeben.

Es sei an dieser Stelle erwähnt, daß die Abkühlung der Schmelze bzw. des Gußkörpers 10 auf unterschiedliche Weise herbeigeführt werden kann. Zunächst einmal ist es möglich, die Schleudertrommel im Bereich der Kühlfläche 9 mit einer entsprechend großen Masse aus einem gut wärmeleitfähigen Werkstoff, beispielsweise aus Kupfer, zu versehen. Figur 1 zeigt eine Einrichtung 15 zur Zwangskühlung in Form von Gebläseschaufeln 16, die als Kühlrippen wirken, wobei die Kühlwirkung durch Gasumwälzung und Wärmeaustausch mit der gekühlten Kammerwand gesteigert werden kann. Figur 3 zeigt die Anordnung eines kühlmitteldurchströmten Hohlraums 33 auf dem Umfang der Kühlfläche 9, und Figur 5 zeigt die bereits beschriebene Berieselungskühlung. Durch sämtliche Kühlmethoden wird die zumindest überwiegend radiale Wärmeabfuhr einerseits und das radial entgegengesetzte Kornwachstum andererseits im Sinne einer gerichteten Erstarrung begünstigt. Die verschiedenen Kühlmethoden lassen sich natürlich auch auf den Gegenstand von Figur 6 übertragen.

Figur 6 zeigt eine ausgesprochene Großanlage für die Massenproduktion von pulverförmigen Partikeln der beschriebenen Art. In diesem Fall ist die Schleudertrommel 43 mit einem Innendurchmesser von 2 m und einer Länge von 4 m beidendig gelagert, und zwar einmal mittels eines ersten Radiallagers 63, das an einem in Pfeilrichtung verschiebbaren Lagerbock 64 befestigt ist. Das andere Ende der Schleudertrommel 43 ist auf einer Verschlußwand 65 gelagert. Der Antrieb der Schleudertrommel 43 erfolgt auch in diesem Falle über einen Getriebemotor 20 und einen Riementrieb 21, wobei die Verbindung mit der Schleudertrommel 43 aus den nachstehend noch näher erläuterten Gründen lösbar ist.

In dem in Figur 6 gezeigten Betriebszustand, in dem der Gußkörper 10 aufgebaut wird, ragt durch die Verschlußwand 65 eine Gießrinne 66 in die Schleudertrommel 43, wobei die Gießrinne 66 auf ihrer über der Kühlfläche 9 verschiebbaren Teillänge mit mehreren Austrittsöffnungen 67 versehen ist. Im vorliegenden Fall handelt es sich um sechs solcher Austrittsöffnungen 67, durch die insgesamt sechs Gießstrahlen erzeugt werden, die durch Pfeile angedeutet sind.

Vor der Außenseite der Verschlußwand 65 ist mit Abstand eine Rückzugskammer 68 für die Gießrinne 66 angeordnet. Von der Rückzugskammer 68, von der nur eine kurze Teillänge dargestellt ist, führt eine Saugleitung 69 zu einem Satz nicht dargestellter Vakuumpumpen. In der Rückzugskammer 68 befindet sich eine Heizeinrichtung 70, durch die die Gießrinne 66 vorgeheizt werden kann.

Seitlich der Gießrinne 66 und zwischen Schleudertrommel 43 und Rückzugskammer 68 befindet sich eine Schmelz- und Gießvorrichtung 71, die als Vakuum-Induktionsofen ausgeführt ist. Ein solcher Vakuum-Induktionsofen ist in der DE 35 30 471 A1 ausführlich beschrieben, so daß hier nur die wesentlichsten Bauteile und Funktionen beschrieben werden sollen: Ein Deckel 72 ist als zentrales Bauteil dieser Schmelz- und Gießvorrichtung 71 auf zwei gasdichten und tangential zum Deckel 72 verlaufende Drehlagern 73 gelagert, die einen großen Durchmesser haben und Durchtrittsöffnungen für die Gießrinne 66 umgeben. An den Deckel 72 ist lösbar ein Schmelztiegel 74 angehängt, und auf dem Deckel 72 befindet sich eine Chargiereinrichtung 75, von der nur der untere Teil dargestellt ist, für das Schmelzgut, und zwischen dem Deckel 72 und der Chargiereinrichtung 75 befindet sich eine Vakuumschleuse 76. Die gesamte Schmelz- und Gießvorrichtung 71 ist um eine durch die Drehlager 73 definierte Achse schwenkbar, und bei dieser Schwenkbewegung tritt über eine Ausgußöffnung 77 die Schmelze in die Gießrinne 66 ein, wenn diese sich in der in Figur 6 gezeigten Position befindet. Durch die Mehrzahl der Austrittsöffnungen 67 verteilt sich die Schmelze gleichmäßig und kontinuierlich auf der Kühlfläche 9, und zwar sowohl in Umfangsrichtung als auch in einer Richtung parallel zur Rotationsachse AR-AR. Sobald der Abguß beendet ist, wird die Abkühlung des Gußkörpers 10 durch eine der weiter oben beschriebenen Maßnahmen beendet. Im Anschluß daran wird die Verbindung zwischen dem Getriebemotor 20 und der Schleudertrommel 43 unterbrochen, und die Schleudertrommel wird an einer Seilwinde 78 aufgehängt und durch Verschiebung des Lagerbocks 64 nach rechts soweit verschoben, daß sich die Verschlußwand 65 nicht mehr in der zugehörigen Öffnung der Schleudertrommel 43 befindet. Die Gießrinne 66 wurde zuvor vollständig in die Rückzugskammer 68 zurückgezogen und wird dort für einen neuen Abgußvorgang vorbereitet.

Der Lagerbock 64 trägt eine waagrechte Kippachse AK, die senkrecht zur Rotationsachse AR-AR und zur Zeichenebene verläuft. Diese Kippachse AK trägt auch das Radiallager 63. Mittels der Seilwinde 78 wird nun die Scheudertrommel 43 um die Kippachse AK herabgeschwenkt, bis die ursprünglich waagrechte Rotationsachse AR-AR die Position AR'-AR' einnimmt, die im wesentlichen senkrecht verläuft.

Da das untere Ende der Schleudertrommel 43 in diesem Falle offen ist, fällt der Gußkörper 10 in Teilstücken in einen darunter befindlichen Transportwagen 79, der das Material des Gußkörpers 10 zu einer Zerkleinerungseinrichtung bringt, die hier jedoch nicht näher dargestellt ist.

Nach dem Entleeren kann die Schleudertrommel 43 mittels der Seilwinde 78 wieder in die waagrechte Lage gebracht und durch Verschieben des Lagerbocks 64 nach links wieder in Verbindung mit der Verschlußwand 65 gebracht werden, so daß die Vorrichtung nach dem Verfahren der Gießrinne 66 nach rechts wieder betriebsbereit ist.

Zur Vermeidung der Übertragung von Erschütterungen ist zwischen der Verschlußwand 65 und dem rechten Drehlager 73 ein Faltenbalg 80 angeordnet. Der Lagerbock 64 befindet sich ebenso wie der Getriebemotor 20 und die Seilwinde 78 auf einer Zwischenplattform 81. Über die gasdichten Drehlager 73 und die Verschlußwand 65 ist auch die Schleudertrommel 43 gas- bzw- vakuumdicht mit der Rückzugskammer 68 verbunden. Damit diese und die Schmelz- und Gießvorrichtung 71 unter Vakuum oder Schutzgas gehalten werden können, ist es zweckmäßig, zwischen der Verschlußwand 65 und dem nächstliegenden Drehlager 73 einen Absperrschieber 82 anzuordnen.

Beim Erfindungsgegenstand erfolgt die Partikelherstellung auf dem Umweg über einen mehr oder weniger spröden Hohlkörper. In allen Fällen begünstigt das Verhältnis von (geringer) Schichtdicke bzw. Wandstärke zu (großem) Durchmesser die Erstarrungsgeschwindigkeit und damit die radiale und feine Kornstruktur mit engem Korngrößenspektrum.

### Beispiel:

In einer auf weniger als 10⁻¹ mbar evakuierten Vorrichtung nach Figur 2 mit einer wassergekühlten Schleudertrommel 8, die einen Durchmesser von 600 mm und eine Länge von 500 mm besaß, wurde deren Drehzahl auf 475 Umdrehungen pro Minute hochgefahren. Die Kühlwasser-Eintrittstemperatur betrug 15 °C und der Kühlwasserdurchsatz 65 Liter pro Minute. Anschließend wurden innerhalb von 45 Sekunden 70 kg Ni-Mischmetall (LaNi₅) mit einer Temperatur, die über der Liquidustemperatur der Schmelze lag, eingegossen. Nach dem Erstarren der Schmelze nach etwa 5 Minuten wurde zwecks Fortsetzung der Kühlung die Drehzahl auf 140 min⁻¹ zurückgenommen und für die Dauer von 15 Minuten beibehalten. Danach wurde die Kammer geflutet und geöffnet: Der hohlzylindrische Gußkörper, der eine Wandstärke zwischen 6 und 13 mm besaß, war unregelmäßig gerissen, allerdings in etwa gleichgroße Stücke. Kurz vor dem Stillstand der Trommel war ein Teil dieser Stücke heruntergefallen und bildete an der tiefsten Stelle der Trommel einen flachen Haufen. Durch die Fliehkraft waren jedenfalls auch die Bruchstücke bis kurz vor dem Stillstand der Trommel in Berührung mit deren Kühlfläche gehalten worden, so daß die sehr wirksame Kühlung durch zentrifugales Anpressen der Bruchstücke aufrechterhalten worden war. Die gerichtet erstarrten Brocken mit einer mittleren Größe von 3 cm ließen sich leicht entfernen und zu Pulver zermahlen. Bei dem LaNi₅ handelt es sich um eine typische Wasserstoff-Speicherlegierung, die als Ersatz für NiCd in aufladbaren Batterien eingesetzt werden kann. Durch die sehr hohe Leistungsdichte und kompakte Ausführung ist es besonders geeignet für eine Vielzahl von elektronischen Geräten, wie z.B. Laptops, Mobilfunkgeräte etc..

## Patentansprüche

1. Verfahren zum Herstellen von Werkstoffen aus Metallen aus der Gruppe Seltenerdmetalle (Lanthanide), Aluminium, Bor, Chrom, Eisen, Kalzium, Magnesium, Mangan, Nickel, Niob, Kobalt, Titan, Vanadium, Zirkonium und deren Legierungen, insbesondere zum Herstellen von Magnetwerkstoffen, Wasserstoffspeichern (Hydridspeichern) und Batterie-Elektroden, wobei man eine Schmelze der Metalle nach dem Prinzip des Schleudergießens von innen auf eine mit hoher Geschwindigkeit um eine Drehachse (A-A) rotierende, zumindest im wesentlichen zylindrische und von außen gekühlte Kühlfläche (9) aufgießt und die Schmelze zu einem Gußkörper (10) erstarren läßt, **dadurch gekennzeichnet**, daß man
a) die Schmelze in einer nichtreaktiven Atmosphäre auf eine rotierende Kühlfläche (9) aufgießt, deren Durchmesser mindestens 200 mm beträgt,
b) die Dicke des Gußkörpers (10) auf maximal 10% des Durchmessers der Kühlfläche (9) begrenzt,
c) die Schmelze durch hohe Abkühlgeschwindigkeit mit zumindest im wesentlichen radialer Erstarrungsrichtung abkühlt und
d) die erstarrte Schmelze zu pulverförmigen Partikeln zerkleinert.

2. Verfahren nach Anspruch 1, **dadurch gekennzeichnet,** daß man die Schmelze auf die rotierende Kühlfläche (9) in einer Dicke aufbringt, die maximal 5%, des Durchmessers der Kühlfläche (9) beträgt.

3. Verfahren nach Anspruch 1, **dadurch gekennzeichnet,** daß der Durchmesser der Kühlfläche (9) zu mindestens 500 mm gewählt wird.

4. Verfahren nach Anspruch 1, **dadurch gekennzeichnet,** daß man mindestens einen Schmelzenstrahl unter axialer Verschiebung parallel zur Rotationsachse (AR-AR) zunächst auf die Kühlfläche (9) und danach auf eine bereits zumindest teilweise abgekühlte Schicht des Gußkörpers (10) aufbringt.

5. Verfahren nach Anspruch 4, **dadurch gekennzeichnet,** daß man den Schmelzenstrahl in Achsrichtung der Kühlfläche hin und her bewegt. .

6. Verfahren nach Anspruch 1, **dadurch gekennzeichnet**, daß man die Schmelze von einem im Innern der Kühlfläche (9) angeordneten Schmelztiegel (24, 53) auf die Kühlfläche (9) aufbringt.

7. Vorrichtung zum Herstellen von Werkstoffen aus Metallen aus der Gruppe Seltenerdmetalle (Lanthanide), Aluminium, Bor, Chrom, Eisen, Kalzium, Magnesium, Mangan, Nickel, Niob, Kobalt, Titan, Vanadium, Zirkonium und deren Legierungen, insbesondere zum Herstellen von Magnetwerkstoffen, Wasserstoffspeichern (Hydridspeichern) und Batterie-Elektroden, mit einer Einrichtung (27, 52, 66) zum Erzeugen mindenstens eines Gießstrahls (30) und mit einer mit hoher Geschwindigkeit um eine Drehachse (A-A) drehbaren Schleudertrommel (8), die eine zumindest im wesentlichen zylindrische und von außen kühlbare Kühlfläche (9) aufweist, **dadurch gekennzeichnet,** daß
a) sowohl die Kühlfläche (9) der Schleudertrommel (8) als auch eine Einrichtung (27, 52, 66) zum Erzeugen mindestens eines Gießstrahls (30) in einer gasdichten Kammer (1, 44, 45) angeordnet sind, in der eine nichtreaktive Atmosphäre erzeugbar ist,
b) die Kühlfläche (9) einen Durchmesser von mindestens 200 mm besitzt und daß
c) als Mittel zur Zerkleinerung der erstarrten Schmelze zu pulverförmigen Partikeln entweder die Schleudertrommel (8) selbst oder eine der Vorrichtung nachgeschaltete Zerkleinerungsvorrichtung einsetzbar ist.

8. Vorrichtung nach Anspruch 7, **dadurch gekennzeichnet,** daß die Kühlfläche (9) einen Durchmesser von mindestens 500 mm besitzt.

9. Vorrichtung nach Anspruch 7, **dadurch gekennzeichnet,** daß die Schleudertrommel (8)
a) auf einer Seite eine geschlossene Stirnwand (11) besitzt, mittels welcher sie koaxial an einer antreibbaren Welle (7) befestigt ist, und
b) auf der anderen Seite offen ist, wobei die Kammer (1) auf der offenen Seite der Schleudertrommel (8) eine Tür (3) besitzt, an deren Innenseite eine Abgußvorrichtung für die Schmelze angeordnet ist.

10. Vorrichtung nach Anspruch 9, **dadurch gekennzeichnet,** daß die Abgußvorrichtung ein innerhalb der gasdichten Kammer (1, 44, 45) kippbar angeordneter Schmelztiegel (24) ist.

11. Vorrichtung nach Anspruch 10, **dadurch gekennzeichnet,** daß zwischen dem Schmelztiegel (24) und der Kühlfläche (9) eine Gießrinne (27) angeordnet ist.

12. Vorrichtung nach Anspruch 11, **dadurch gekennzeichnet,** daß die Gießrinne (27) parallel zur Rotationsachse (AR-AR) beweglich angeordnet ist.

13. Vorrichtung nach Anspruch 7, **dadurch gekennzeichnet,** daß die Schleudertrommel (42, 43) mit ihrer Kühlfläche (9) selbst mindestens einen Teil einer gasdichten Kammer (44, 45) bildet.

14. Vorrichtung nach Anspruch 13, **dadurch gekennzeichnet,** daß die Schleudertrommel (42) drehfest mit einem Ringfortsatz (46) versehen ist, der gasdicht über ein Radiallager (47) mit einem stationären Lagerring (48) zusammenwirkt.

15. Vorrichtung nach Anspruch 14, **dadurch gekennzeichnet,** daß der stationäre Lagerring (48) an einer Kammerwand (50) befestigt ist, die im Innern des Lagerrings (48) mit einer öffnung (51) zum Einführen einer Gießvorrichtung (52) versehen ist, die von einer Verschlußplatte (55) für die besagte öffnung (51) absteht.

16. Vorrichtung nach Anspruch 13, **dadurch gekennzeichnet,** daß die Schleudertrommel (43) um eine waagrechte Kippachse (AK) schwenkbar ist, die senkrecht zur Rotationsachse (AR-AR) verläuft, und daß eine beim Kippen nach unten gelangende, beim Gießen durch eine Verschlußwand (65) verschließbare Öffnung der Schleudertrommel die Entleerung des erstarrten Gußkörpers (10) nach unten ermöglicht.

17. Vorrichtung nach Anspruch 16, **dadurch gekennzeichnet,** daß durch die Verschlußwand (65) eine Gießrinne (66) in die Schleudertrommel (43) einführbar ist, und daß vor der Außenseite der Verschlußwand (65) eine Rückzugskammer (68) für die Gießrinne (66) angeordnet ist.

18. Vorrichtung nach Anspruch 17, **dadurch gekennzeichnet**, daß die Gießrinne (66) auf ihrer über die Kühlfläche (9) verschiebbaren Teillänge mit mehreren Austrittsöffnungen (67) zur Ausbildung mehrerer Gießstrahlen versehen ist.

19. Vorrichtung nach Anspruch 7, **dadurch gekennzeichnet,** daß die Schleudertrommel (8) auf ihrer Außenseite mit mindestens einem Kranz von Gebläseschaufeln (16) versehen ist.

20. Vorrichtung nach Anspruch 7, **dadurch gekennzeichnet,** daß die Schleudertrommel (32) auf ihrem Außenumfang mit mindestens einem Hohlraum (33) versehen ist, der über die Welle (7) an einen Kühlmittelkreislauf (34) angeschlossen ist.

## Claims

1. Process for the production of materials of metals from the group rare earth metals (lanthanide), aluminium, boron, chromium, iron, calcium, magnesium, manganese, nickel, niobium, cobalt, titanium, vanadium, circonium and their alloys, in particular for the production of magnetic materials, hydrogen accumulators (hydride accumulators) and battery electrodes, where a melt of the metals is poured by the principle of centrifugal casting from the inside onto a cooling surface (9), which rotates at high speed around a rotary axis (A-A) and which is at least substantially cylindrical and cooled from the outside, and the melt is solidified to form a cast body (10), **characterised in that**
a) the melt is poured in a non-reactive atmosphere onto a rotating cooling surface (9) the diameter of which is minimum 200 mm;
b) the thickness of the cast body (10) is limited to maximum 10% of the diameter of the cooling surface (9);
c) the melt is cooled by high cooling speed in an at least substantially radial solidification direction; and
d) the solidified melt is reduced to powdered particles.

2. Process according to Claim 1, **characterised in that** the melt is applied to a rotating cooling surface (9) at a thickness of maximum 5% of the diameter of the cooling surface (9).

3. Process according to Claim 1, **characterised in that** the diameter of the cooling surface (9) is chosen to be at least 500 mm.

4. Process according to Claim 1, **characterised in that** at least one melt stream is applied under axial displacement parallel to the rotary axis (AR-AR) initially to the cooling surface (9) and thereafter to an already at least partially cooled layer of the cast body (10).

5. Process according to Claim 4, **characterised in that** the melt stream is moved to and fro in the axial direction of the cooling surface.

6. Process according to Claim 1, **characterised in that** the melt is applied from a melting crucible (24,53), which is arranged inside the cooling surface (9), onto the cooling surface (9).

7. Apparatus for the production of materials of metals from the group rare earth metals (lanthanide), aluminium, boron, chromium, iron, calcium, magnesium, manganese, nickel, niobium, cobalt, titanium, vanadium, circonium and their alloys, in particular for the production of magnetic materials, hydrogen accumulators (hydride accumulators) and battery electrodes, with a device (27, 52, 66) for producing at least one casting stream (30) and with a centrifugal drum (8), which is rotary at high speed around a rotary axis (A-A) and which comprises an at least substantially cylindrical cooling surface (9) which is cooled from outside, **characterised in that**
a) both the cooling surface (9) of the centrifugal drum (8) and a device (27, 52, 66) for producing at least one casting stream (30) are configured in a gastight chamber (1, 44, 45) wherein a non-reactive atmosphere can be produced;
b) the cooling surface (9) has a diameter of at least 200 mm; and
c) either the centrifugal drum (8) itself or a reducing device downstream of the device is applied as a means for reducing the solidified melt into powdered particles.

8. Apparatus according to Claim 7, **characterised in that** the cooling surface (9) has a diameter of minimum 500 mm.

9. Apparatus according to Claim 7, **characterised in that** the centrifugal drum (8)
a) comprises on one side a sealed end wall (11) by means of which it is coaxially mounted on a driven shaft (7); and
b) it is open at the other side, and the chamber (1) has at the open side of the centrifugal drum (8) a door (3), at the inside of which is configured a casting device for the melt.

10. Apparatus according to Claim 9, **characterised in that** the casting device is a melting crucible (24) arranged to be tiltable within the gastight chamber (1, 44, 45).

11. Apparatus according to Claim 10, **characterised in that** a pouring trough (27) is configured between the melting crucible (24) and the cooling surface (9).

12. Apparatus according to Claim 11, **characterised in that** the pouring trough (27) is arranged to be movable parallel to the rotary axis (AR-AR).

13. Apparatus according to Claim 7, **characterised in that** the centrifugal drum (42, 43) with its cooling surface (9) forms itself at least part of a gastight chamber (44, 45).

14. Apparatus according to Claim 13, **characterised in that** the centrifugal drum (42) is non-rotationally provided with an annular extension (46) which co-operates in a gastight manner via a radial bearing (47) with a stationary bearing ring (48).

15. Apparatus according to Claim 14, **characterised in that** the stationary bearing ring (48) is attached to a chamber wall (50) which is inside the bearing ring (48) provided with an opening (51) for introduction of a pouring device (52) which projects from a sealing plate (55) for said opening (51).

16. Apparatus according to Claim 13, **characterised in that** the centrifugal drum (43) is pivotal around a horizontal tilt axis (AK) which extends vertically to the rotary axis (AR-AR), and an opening of the centrifugal drum, which arrives at the bottom during tilting and which is sealable by means of a sealing wall (65) during casting, permits downward emptying of the solidified cast body (10).

17. Apparatus according to Claim 16, **characterised in that** a pouring trough (66) is introduced through the sealing wall (65) into the centrifugal drum (43), and in front of the outside of the sealing wall (65) is arranged a retracting chamber (68) for the pouring trough (66).

18. Apparatus according to Claim 17, **characterised in that** the pouring trough (66) is over its partial length which is displaceable over the cooling surface (9) provided with a plurality of outlet openings (67) for the purpose of establishing a plurality of casting streams.

19. Apparatus according to Claim 7, **characterised in that** the centrifugal drum (8) is at its outside provided with at least one rim of blower blades (16).

20. Apparatus according to Claim 7, **characterised in that** the centrifugal drum (32) is at its outside periphery provided with at least one hollow space (33) which is connected via the shaft (7) to a refrigerant circuit (34).

## Revendications

1. Procédé pour la production de matériaux à partir des métaux parmi le groupe comprenant les métaux des terres rares (lanthanides), l'aluminium, le bore, le chrome, le fer, le calcium, le magnésium, le manganèse, le nickel, le niobium, le cobalt, le titane, le vanadium, le zirconium et leurs alliages, en particulier pour produire des matériaux magnétiques, des accumulateurs d'hydrogène (accumulateurs d'hydrure) et des électrodes de piles ou de batteries, dans lequel on coule une fonte des métaux selon le principe de la coulée centrifuge depuis l'intérieur sur une surface de refroidissement (9) en rotation à une vitesse élevée autour d'un axe de rotation (A-A), laquelle est du moins sensiblement cylindrique et refroidie depuis l'extérieur, et on laisse solidifier la fonte en un corps coulé (10), caractérisé en ce que :
a) on coule la fonte dans une atmosphère non réactive sur une surface de refroidissement en rotation (9) dont le diamètre s'élève au moins à 200 mm,
b) on limite l'épaisseur du corps coulé (10) à 10 % au maximum du diamètre de la surface de refroidissement (9),
c) on refroidit la fonte à une vitesse de refroidissement élevée avec une direction de solidification au moins sensiblement radiale, et
d) on fragmente la fonte solidifiée en particules en forme de poudre.

2. Procédé selon la revendication 1, caractérisé en ce que l'on applique la fonte sur la surface de refroidissement (9) en rotation, sur une épaisseur qui s'élève au maximum à 5 % du diamètre de la surface de refroidissement (9).

3. Procédé selon la revendication 1, caractérisé en ce que l'on choisit pour la surface de refroidissement (9) un diamètre d'au moins 500 mm.

4. Procédé selon la revendication 1, caractérisé en ce que l'on applique au moins un jet de fonte avec déplacement axial parallèlement à l'axe de rotation (AR-AR) tout d'abord sur la surface de refroidissement (9) et ensuite sur une couche déjà au moins partiellement refroidie du corps coulé (10).

5. Procédé selon la revendication 4, caractérisé en ce que l'on déplace en va-et-vient le jet de fonte en direction axiale de la surface de refroidissement.

6. Procédé selon la revendication 1, caractérisé en ce que l'on applique la fonte sur la surface de refroidissement (9) depuis un creuset (24, 53) agencé à l'intérieur de la surface de refroidissement (9).

7. Dispositif pour la production de matériaux à partir des métaux parmi le groupe comprenant les métaux des terres rares (lanthanides), l'aluminium, le bore, le chrome, le fer, le calcium, le magnésium, le manganèse, le nickel, le niobium, le cobalt, le titane, le vanadium, le zirconium et leurs alliages, en particulier pour produire des matériaux magnétiques, des accumulateurs d'hydrogène (accumulateurs d'hydrure) et des électrodes de piles ou de batteries, comportant une unité (27, 52, 66) pour produire au moins un jet de fonte (30), et un tambour centrifuge (8) en rotation à une vitesse élevée autour d'un axe de rotation (A-A), ledit tambour comprenant une surface de refroidissement (9) au moins sensiblement cylindrique et susceptible d'être refroidie depuis l'extérieur, caractérisé en ce que :
a) la surface de refroidissement (9) du tambour centrifuge (8) ainsi qu'une unité (27, 52, 66) pour produire au moins un jet de fonte (30) sont agencées dans une chambre (1, 44, 45) étanche aux gaz dans laquelle peut être établie une atmosphère non réactive,
b) la surface de refroidissement (9) possède un diamètre d'au moins 200 mm, et
c) soit le tambour centrifuge (8) lui-même, soit un dispositif de fragmentation agencé en aval du dispositif, est susceptible d'être utilisé comme moyen pour fragmenter en particules en forme de poudre la fonte solidifiée.

8. Dispositif selon la revendication 7, caractérisé en ce que la surface de refroidissement (9) possède un diamètre d'au moins 500 mm.

9. Dispositif selon la revendication 7, caractérisé en ce que le tambour centrifuge (8) :
a) possède sur un côté une paroi frontale fermée (11) au moyen de laquelle il est fixé coaxialement sur un arbre (7) susceptible d'être entraîné, et
b) est ouvert sur l'autre côté, la chambre (1) possédant sur le côté ouvert du tambour centrifuge (8) une porte (3), sur le côté intérieur de laquelle est agencé un dispositif d'évacuation pour la fonte.

10. Dispositif selon la revendication 9, caractérisé en ce que le dispositif d'évacuation est un creuset (24) agencé en basculement à l'intérieur de la chambre (1, 44, 45) étanche aux gaz.

11. Dispositif selon la revendication 10, caractérisé en ce qu'une goulotte de coulée (27) est agencée entre le creuset (24) et la surface de refroidissement (9).

12. Dispositif selon la revendication 11, caractérisé en ce que la goulotte de coulée (27) est agencée de façon mobile parallèlement à l'axe de rotation (AR-AR).

13. Dispositif selon la revendication 7, caractérisé en ce que le tambour centrifuge (42, 43) forme par sa surface de refroidissement (9) elle-même au moins une partie d'une chambre (44, 45) étanche aux gaz.

14. Dispositif selon la revendication 13, caractérisé en ce que le tambour centrifuge (42) est pourvu solidairement en rotation d'un prolongement annulaire (46) qui coopère avec un anneau de montage stationnaire (48) de façon étanche via un palier radial (47).

15. Dispositif selon la revendication 14, caractérisé en ce que l'anneau de montage stationnaire (48) est fixé sur une paroi de chambre (50) qui est pourvue, à l'intérieur de l'anneau de montage (48), d'une ouverture (51) pour introduire un dispositif de coulée (52) qui dépasse d'un plateau de fermeture (55) destiné à ladite ouverture (51).

16. Dispositif selon la revendication 13, caractérisé en ce que le tambour centrifuge (43) est en basculement autour d'un axe de basculement horizontal (AK) qui s'étend perpendiculairement à l'axe de rotation (AR-AR), et en ce qu'une ouverte du tambour centrifuge, laquelle parvient vers le bas lors du basculement et peut être refermée par une paroi d'obturation (65) pendant de la coulée, permet le vidage vers le bas du corps coulé solidifié (10).

17. Dispositif selon la revendication 16, caractérisé en ce qu'une goulotte de coulée (66) peut être introduite à travers la paroi d'obturation (65) dans le tambour centrifuge (43), et en ce qu'une chambre de rétraction (68) pour la goulotte de coulée (66) est agencée devant le côté extérieur de la paroi d'obturation (65).

18. Dispositif selon la revendication 17, caractérisé en ce que la goulotte de coulée (66) est pourvue, sur sa longueur partielle mobile par-dessus la surface de refroidissement (9), de plusieurs ouvertures de sortie (67) destinées à réaliser plusieurs jets de fonte.

19. Dispositif selon la revendication 7, caractérisé en ce que le tambour centrifuge (8) est pourvu sur son côté extérieur d'au moins une couronne d'aubes de ventilation (16).

20. Dispositif selon la revendication 7, caractérisé en ce que le tambour centrifuge (32) est pourvu sur sa périphérie extérieure d'au moins une cavité (33) qui est branchée via l'arbre (7) à un circuit de réfrigérant (34).
